# EUROPEAN PATENT APPLICATION

(11) **EP 1 708 028 A2**
(43) Date of publication of application: **04.10.2006**
(21) Application number: 06006022.5
(22) Date of filing: 23.03.2006
(51) Int. Cl.: G03F 7/20, G03F 9/00

(54) **Optical element, exposure apparatus, and device manufacturing method**

(30) Priority: 30.03.2005 JP 2005099416
(71) Applicant: CANON KABUSHIKI KAISHA, Ohta-ku, Tokyo (JP)
(72) Inventor: Yamamoto, Sumitada, Techn. Eng., Tokyo (JP)
(74) Representative: Weser, Wolfgang

(57) **Abstract**

An optical element for an exposure apparatus is disclosed, where the exposure apparatus has a projection optical system configured to project a pattern of an original plate illuminated with extreme ultraviolet light from a light source onto a substrate and exposes the substrate to the light via the original plate and the projection optical system. The optical element is to be placed in one of a first path of the light located in a side of the light source with respect to the original plate and a second path of the light located in a side of the substrate with respect to the original plate. The element includes a film configured to transmit the extreme ultraviolet light, and a shield placed on the film and configured to shield part of said film from the extreme ultraviolet light.

## Description

### FIELD OF THE INVENTION

The present invention relates to an optical element suitable for measurement using extreme ultraviolet light, an exposure apparatus incorporating the optical element, and a device manufacturing method using the exposure apparatus.

### BACKGROUND OF THE INVENTION

Generally, manufacturing processes of semiconductor devices composed of super minute patterns such as VLSI circuits employ a reduced projection exposure apparatus which burns circuit patterns drawn on a mask upon a substrate coated with a photosensitive material by projecting the circuit patterns onto the substrate on a reduced scale. Increases in packaging density of semiconductor devices demand further miniaturization of pattern line widths. As a result, there has been continuous improvement in resolution to accommodate improved resist processes and miniaturized exposure apparatus. Thus, light sources for exposure apparatus have been using increasingly shorter wavelengths, such as from KrF excimer laser (with a wavelength of 248 nm) to ArF excimer laser (with a wavelength of 193 nm) and to F₂ laser (with a wavelength of 157 nm). To burn finer patterns efficiently, reduced projection exposure apparatus which use extreme ultraviolet light (EUV light) with shorter wavelengths than ultraviolet light, i.e., with wavelengths on the order of 10 to 15 nm, are currently under development.

On the other hand, along with the improvement of resolution and miniaturization of semiconductor devices, increasingly tighter tolerances are required for alignment between mask patterns and patterns on photosensitive substrates. Description will be given below of alignment between a mask pattern and a pattern on a photosensitive substrate on an ordinary reduced projection exposure apparatus which does not use EUV light.

Conventionally, the following two methods are available to observe an alignment mark on a wafer, i.e., a photosensitive substrate, to obtain positional information about the wafer.
1. Off-axis method which measures the alignment mark on a wafer without using a projection optical system.
2. TTR (Through The Reticle) method which detects relative positional relationship between a wafer and reticle by observing them simultaneously using a projection optical system.

Of the two methods, the off-axis method is used for wafer-by-wafer position measurement because the TTR method requires longer measurement time. The off-axis method employs a wafer inspection microscope (hereinafter referred to as an off-axis microscope). Position measurement under an off-axis microscope, which does not use a projection optical system, not only allows the use of any wavelength, but also allows the use of a light source with a wide wavelength band. Advantages of using light with a wide band of wavelengths for position measurement include that thin-film interference effects on the photosensitive material (resist) applied to a wafer can be removed.

However, when aligning a wafer and reticle using an off-axis microscope, it is not possible to measure observation position and exposure position directly. Thus, it is necessary to determine a so-called base line amount in advance, where the base line amount is the distance between the center of measurement under the off-axis microscope and center of a projected pattern image on a reticle (center of exposure). When performing the alignment, a deviation of an alignment mark in a shot on the wafer from the center of measurement is measured under the off-axis microscope. After that, the wafer is moved from the off-axis microscope position by a distance equal to the sum of the base line amount and the deviation, thereby aligning the center of the shot area with the center of exposure accurately. However, the base line amount can change gradually with time during the use of the exposure apparatus. Such changes in the base line will make it impossible to feed the center of a shot on a wafer to the center of a projected pattern image on a reticle, resulting in reduced alignment accuracy (superimposition accuracy). Thus, it is necessary to take base line measurements (calibration measurements) to accurately measure the distance between the center of measurement under the off-axis microscope and center of a projected pattern image on a reticle on a regular basis. The TTR measurement system must be used for the base line measurements.

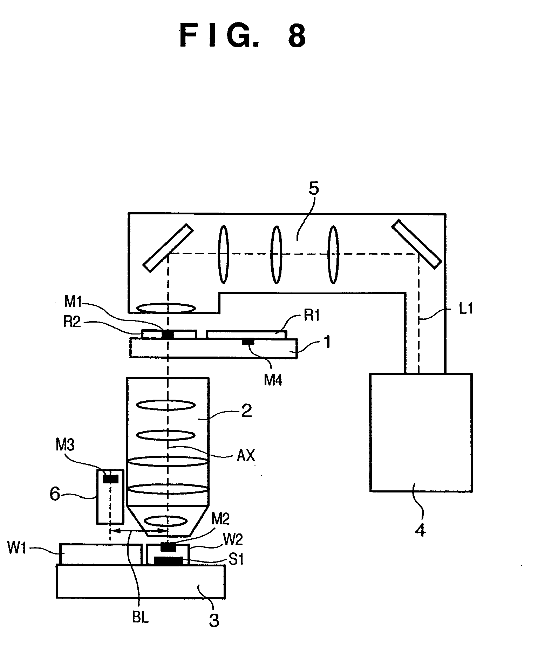

FIG. 8 is a diagram schematically showing the principle of base line measurement on a projection exposure apparatus. A dummy reticle R2 bears a slit-shaped mark M1 within an exposure area of a projection optical system 2. As shown in FIG. 8, the dummy reticle R2 is held on a reticle drive stage 1, which moves in such a way that the center of the dummy reticle R2 will coincide with an optical axis AX of the projection optical system 2. On a wafer drive stage 3, a dummy wafer W2 which bears a mark M2 equivalent to M1 is mounted at an image-forming position in the projection optical system 2, keeping clear of a wafer W1. The mark M2 on the dummy wafer W2 is a slit-shaped light-transmitting area created by placing a light shielding member on an exposure light-transmitting member. A light quantity sensor S1 is placed under the mark M2. The wafer drive stage 3 is positioned using a laser interferometer (not shown) in such a way as to bring the mark M2 into position in a projection area of the projection optical system 2 and exposure light L1 is directed into the projection optical system 2 via an illumination optical system 5 by operating an exposure light source laser 4. While monitoring the light quantity from the light quantity sensor S1 placed under the mark M2, position which maximizes the light quantity is found by moving the wafer stage 3 slightly in X, Y, and Z directions. The position which maximizes the light quantity makes the mark M1 on the dummy reticle and mark M2 on the dummy wafer W2 coincide in relative position.

An off-axis microscope 6 is placed outside the projection optical system 2 (outside the exposure area). On the side of a projected image, the optical axis of the off-axis microscope 6 is parallel to the optical axis AX of the projection optical system 2. An index mark M3 for use as a reference for position measurement of the mark on the wafer W1 or mark M2 on the dummy wafer W2 is provided in the off-axis microscope 6. The index mark M3 is located at a position conjugate to a projected image plane (a surface of the wafer W1 or surface of the dummy wafer W2).

The position of the wafer drive stage 3 when the mark M1 on the dummy reticle R2 and mark M2 on the dummy wafer W2 are aligned with each other is measured by the laser interferometer (not shown). The value obtained is denoted by X1. Also, the position at which the wafer stage 3 is located when the index mark M3 in the off-axis microscope 6 is aligned with the mark M1 is measured by the laser interferometer. The value obtained is denoted by X2. In this case, a base line amount BL is determined by calculating the difference (X1 - X2). The base line amount BL is used later as a reference quantity when measuring an alignment mark on the wafer W1 by the off-axis microscope 6 and sending it to under the projection optical system 2. Let XP denote the distance between the center of a shot (exposure field) on the wafer W1 and the alignment mark and let X3 denote the position of the wafer drive stage 3 when the alignment mark on the wafer W1 coincides with the index mark M3 in the off-axis microscope 6. To make the center of the shot coincide with a reticle center C, the wafer drive stage 3 can be moved to the position determined by "X3 - BL - XP."

To perform the alignment in this way, first, the position of the alignment mark on the wafer W1 is measured using the off-axis microscope 6. Subsequently, by simply feeding the wafer drive stage 3 by a predetermined amount in relation to the base line amount BL, it is possible to superimpose a reticle R1 pattern accurately upon the shot area on the wafer W1 for exposure. However, it is necessary to measure distance between a reticle set mark M4 and the mark M1 on the dummy reticle R2 by some other means and align the reticle R1 with the reticle set mark M4 in advance. Incidentally, although a one-dimensional direction has been taken into consideration in the above description, actually two-dimensional directions should be taken into consideration.

In this way, to align a reticle with a wafer via a projection optical system, a system is used which measures light quantity using a sensor placed under a mark formed by placing a light shielding member on a dummy wafer made of an exposure light-transmitting member.

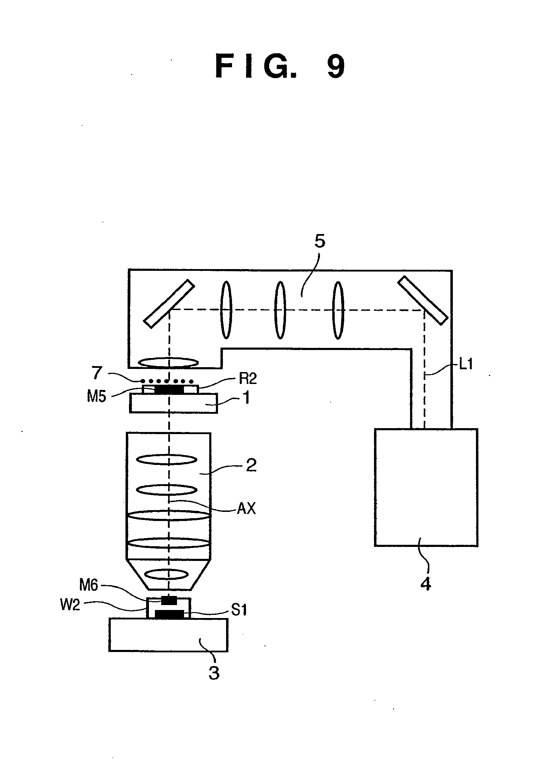

Calibration measurement using the TTR-method has been described above. A similar setup is used for aberration measurement in a projection optical system. FIG. 9 is a schematic diagram of typical aberration measurement system for an exposure apparatus. Components having the same functions as those in FIG. 8 are denoted by the same reference numerals/characters as the corresponding components in FIG. 8, and description thereof will be omitted.

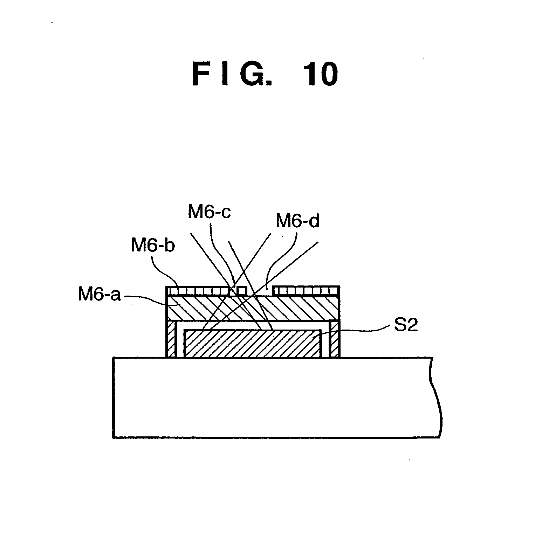

As shown in FIG. 9, an aberration measurement system has a diffraction grating 7 in front of a reticle surface to diffract light. On the downstream side of the diffraction grating 7, a mark M5 with a slit-shaped or pinhole-shaped transparent part is placed near the reticle surface. The mark M5 cancels out the aberration caused by the illumination optical system 5 or diffraction grating 7 and an illuminating beam enters the projection optical system 2. A mark M6 formed by placing a light shielding member on an exposure light-transmitting member such as quartz is provided on a wafer-side image plane. The mark M6 has a slit-shaped or pinhole-shaped transparent part (M6-c in FIG. 10) similar to that of the mark M5 and a window-shaped large transparent part (M6-d in FIG. 10) on the upstream surface of the exposure light-transmitting member. A CCD camera S2 is placed under the mark M6 on the wafer image plane.

Wavefront aberration is removed from an exposure light L1 by the slit-shaped or pinhole-shaped mark M5 placed on the reticle surface. Thus, the exposure light which enters and exits the projection optical system 2 contains only aberration produced in the projection optical system 2. FIG. 10 is an enlarged schematic view of the wafer-side mark M6 on the dummy wafer W2 and part around the CCD camera S2. In FIG. 10, reference character M6-a-denotes an excimer laser-transparent member, such as quartz, which is used as a parent material on which a light shielding member M6-b such as chromium is placed to produce a desired mark shape. The exposure light reaches a surface of the CCD camera S2 after passing through the slit or pinhole M6-c in FIG. 10 which cancels out the aberration contained in the exposure light. On the other hand, the exposure light passing through the window M6-d on the mark M6 reaches the surface of the CCD camera S2, still containing the wavefront aberration produced in the projection optical system 2. The former is referred to as a reference beam and the latter is referred to as a sample beam. The difference in wavefront between the two beams is the wavefront aberration produced in the projection optical system 2. The wavefront aberration is observed as interference fringes when taken into the CCD camera S2 as an image. Image processing of the interference fringes makes it possible to measure wavefront aberration quantitatively up to the 36th term of Zernike polynomials.

Besides, a configuration in which a pinhole is provided in the wafer image plane to transmit the exposure light and a CCD is placed under it is also used to measure pupil-fill intensity distribution in an illumination optical system. In this way, systems widely used currently involve creating a desired mark by placing a light shielding member on an exposure light-transmitting member, installing a sensor under the mark, and observing light quantity or an image passing through the mark. Incidentally, a technique for measuring the base line using non-exposure light on an EUV exposure apparatus is disclosed in Japanese Patent Laid-Open No. 2002-353088.

As described above, alignment measurement, aberration measurement, pupil-fill intensity distribution measurement, and the like involve creating a desired mark by placing a light shielding member on an exposure light-transmitting member which serves as a parent material, installing a sensor under the mark, and observing the light quantity or image of exposure light passing through the mark. However, exposure apparatus which use EUV light as a light source cannot use typical measurement systems such as those described above.

Unlike excimer laser exposure apparatus, EUV exposure apparatus use almost no exposure light-transmitting member. This is because typical transparent members cause great loss of exposure light with a very short wavelength such as EUV light, making it difficult to use a transmissive optical system. Thus, both EUV-based illumination optical system and projection optical system are constituted of mirror-based reflection optical systems. Regarding reticles, reflective reticles are conceived. Reflective reticles consist of absorption bands formed on a reflective multilayer film formed on zero-expansion glass and produce reflected light of desired patterns.

To perform alignment by the TTR method on an EUV exposure apparatus configured as described above, it is necessary to:
(1) install a dummy retile by placing a light shielding member in such a way as to provide a slit-shaped reflector; and
(2) put a mark with a slit-shaped transparent part whose size is reduced by a reduction ratio of the projection optical system on the dummy wafer and install a light quantity sensor under the mark to measure the quantity of transmitted light.

A problem is that the EUV light may not be able to pass through quartz M6-a such as shown in FIG. 10. An exposure apparatus whose light source has a wavelength longer than F₂ laser can use a dummy wafer as shown in FIG. 10. That is, the exposure apparatus can have a configuration in which light transmitted through a mark enters a sensor under the mark, where the mark is formed by placing a light shielding member on a glass member a few millimeters thick. However, EUV light cannot pass through quartz and other glass members. Consequently, the transmitted light does not enter the sensor installed under the dummy wafer. This makes it impossible to take measurements.

In this way, EUV-based exposure apparatus do not allow marks to be created on glass. To deal with this problem, it is conceivable to create a mark on the dummy wafer by attaching an absorption band on a reflecting surface as is the case with the reticle. However, this configuration makes it necessary to provide space for a sensor which detects the light reflected from the mark on the dummy wafer.

### SUMMARY OF THE INVENTION

The present invention has been made in view of the above difficulty found by the inventor's dedicated study and has as its exemplary object to provide an optical element suitable for measurement using extreme ultraviolet light for which it is difficult to use a transmissive optical element, an exposure apparatus incorporating the optical element, and a device manufacturing method using the exposure apparatus.

According to one aspect of the present invention, there is provided an optical element for an exposure apparatus which has a projection optical system configured to project a pattern of an original plate illuminated with extreme ultraviolet light from a light source onto a substrate and exposes the substrate to the light via the original plate and the projection optical system, the optical element being to be placed in one of a first path of the light located in a side of the light source with respect to the original plate and a second path of the light located in a side of the substrate with respect to the original plate, the element comprising: a film configured to transmit the extreme ultraviolet light; and a shield placed on the film and configured to shield part of the film from the extreme ultraviolet light.

Also, according to another aspect of the present invention, there is provided an exposure apparatus which has a projection optical system configured to project a patterns of an original plate illuminated with extreme ultraviolet light from a light source onto a substrate and exposes the substrate to the light via the original plate and the projection optical system, the apparatus comprising: an optical element which as defined above, configured to be placed in one of a first path of the light located in a side of the light source with respect to the original plate and a second path of the light located in a side of the substrate with respect to the original plate.

Further, according to another aspect of the present invention, there is provided an exposure apparatus which exposes a substrate to extreme ultraviolet light via an original plate, the apparatus comprising: a projection optical system configured to project a pattern of the original plate onto the substrate: a substrate stage configured to hold the substrate and to move; an optical element as defined above, placed on the substrate stage; and a detector configured to detect extreme ultraviolet light emitted from the projection optical system and transmitted through the optical element.

Furthermore, according to another aspect of the present invention, there is provided a method of manufacturing a device, the method comprising steps of: exposing a substrate to light via an original plate using an exposure apparatus as defined above, developing the exposed substrate; and processing the developed substrate to manufacture the device.

Other features and advantages of the present invention will be apparent from the following description taken in conjunction with the accompanying drawings, in which like reference characters designate the same or similar parts throughout the figures thereof.

### BRIEF DESCRIPTION OF THE DRAWINGS

The accompanying drawings, which are incorporated in and constitute a part of the specification, illustrate embodiments of the invention and , together with the description, serve to explain the principles of the invention.
FIG. 1 is a schematic diagram showing a schematic configuration of an exposure apparatus according to a first embodiment;
FIG. 2 is a flowchart illustrating procedures for base line measurement according to the first embodiment;
FIG. 3 is an enlarged schematic view of a mark on a dummy wafer and part around a light quantity detection sensor according to the first embodiment;
FIG. 4 is an enlarged schematic view showing a variation to the mark on the dummy wafer and part around the light quantity detection sensor according to the first embodiment;
FIG. 5 is a schematic diagram showing a schematic configuration of an exposure apparatus according to a second embodiment;
FIG. 6 is a flowchart illustrating procedures for wavefront aberration measurement according to the second embodiment;
FIG. 7 is an enlarged schematic view of a mark on a dummy wafer and part around a light quantity detection sensor according to the second embodiment;
FIG. 8 is a schematic diagram illustrating a base line measurement method on a typical exposure apparatus;
FIG. 9 is a schematic diagram showing an aberration measurement method in a projection optical system of a typical exposure apparatus;
FIG. 10 is a schematic diagram showing a region near a wafer image plane of a typical exposure apparatus;
FIG. 11 is a diagram illustrating a flow of a device manufacturing process; and
FIG. 12 is a diagram illustrating a wafer process.

### DETAILED DESCRIPTION OF THE PREFERRED EMBODIMENTS

Preferred embodiments of the present invention will now be described in detail in accordance with the accompanying drawings.

In the following embodiments, description will be given of suitable construction of the following parent materials used on an exposure apparatus which employs EUV light as a light source:
(1) parent material for a mark provided on a light quantity sensor on a wafer stage and used for TTR measurement;
(2) parent material for a mark provided on a CCD camera on the wafer stage and used for measurement of aberration in a projection optical system; and
(3) parent material for diffraction grating, pinhole, and the like.

These parent materials are thin films of particular materials not exceeding a certain thickness. They are sufficiently transparent to EUV light. Thus, by placing a light shielding member on the parent material, it is possible to create a desired optical element such as a desired mark or diffraction grating.

### [First Embodiment]

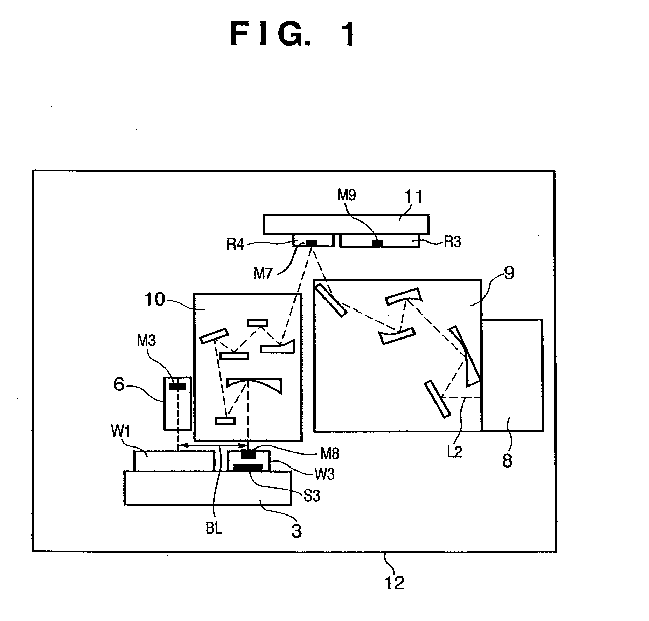

FIG. 1 is a schematic diagram illustrating a schematic configuration of an exposure apparatus according to a first embodiment. The same components/functions as those in FIG. 8 are denoted by the same reference numerals/characters as the corresponding components/functions in FIG. 8. In the exposure apparatus according to this embodiment, an EUV light source 8 (hereinafter referred to as the light source 8) outputs EUV light. An EUV illumination optical system 9 (hereinafter referred to as the illumination optical system 9) forms EUV light L2 emitted from the light source 8 into luminous flux of a predetermined shape. A reflective projection optical system 10 focuses the EUV light L2 on a wafer W1 which is a photosensitive substrate after it is formed into a predetermined shape by the illumination optical system 9 and reflected by a reflective reticle R3 for EUV (hereinafter referred to as the reticle R3). The reticle R3 and wafer W1 are mounted on a reticle drive stage 11 and wafer drive stage 3, respectively. Scanning exposure is enabled by driving the two stages (11 and 3) in synchronization by changing a feed ratio according to a magnification of the projection optical system 10. Position measurement of the two stages (11 and 3) are performed by a laser interferometer (not shown).

A reflective dummy reticle R4 (hereinafter referred to as the dummy reticle R4) is mounted on the stage 11 and a mark M7 equipped with a slit-shaped reflector is mounted on the reflective dummy reticle R4. On the other hand, a dummy wafer W3 is mounted on the stage 3 and a mark M8 equipped with a slit-shaped transparent part is mounted on the dummy wafer W3. The dummy reticle R4 and dummy wafer W3 are used for base line measurement. Incidentally, parent material of the dummy wafer W3 is a thin film of Si, SiC, SiNx, diamond, or diamond-like carbon 2 µm or less in thickness. The diamond-like carbon is an amorphous hard carbon film created by mainly carbon and hydrogen and is also known as amorphous carbon. The mark M8 equipped with a slit-shaped reflector of tantalum, tungsten, or other metal is placed on the thin film. Besides, a EUV light quantity detection sensor S3 (hereinafter referred to as the light quantity detection sensor S3) is installed under the mark M8.

An exemplary method for making a mark on a thin film of an optical element is as follows. That is, optical lithography technology used for semiconductor device manufacture can be used for optical elements. For example, a light shielding body is vapor-deposited on a thin film, a photoresist which is a photosensitive material is applied to it, and a pattern corresponding to the mark to be formed is transferred to the photoresist by an electron beam exposure apparatus. Subsequently, the photoresist is developed (an area corresponding to the mark is removed from the resist) and the light shielding body is removed by etching using the developed photoresist as a mask, thereby creating a blank area (extreme ultraviolet light-transmitting part) as the mark.

A position detection mark M9 is mounted on the reticle R3. The distance between the mark M9 and the mark M7 on the dummy reticle is measured by a reticle microscope and/or interferometer (both not shown). An off-axis microscope 6 is installed on the side of the wafer to measure position of a wafer alignment mark. The off-axis microscope 6 incorporates an index mark M3 for use as a reference for position measurement of the mark on the wafer W1 or mark M8 on the dummy wafer W3. Incidentally, in the above configuration, all areas transparent to EUV light are enclosed in a vacuum chamber 12 which is maintained under vacuum.

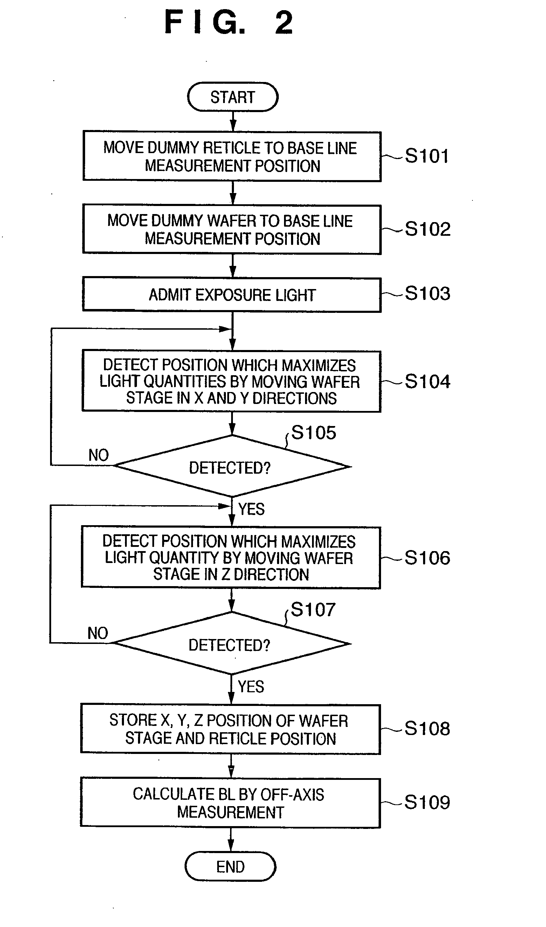

Next, description will be given of an alignment process performed on the exposure apparatus described above. FIG. 2 is a flowchart illustrating procedures for base line measurement according to this embodiment. Incidentally, the procedures shown in FIG. 2 are carried out as a controller (not shown) of the exposure apparatus according to the present embodiment controls various parts of the exposure apparatus. The controller has a storage which stores a computer program corresponding to the procedures and CPU which executes the computer program stored in the storage.

When scan-exposing the pattern on the reticle R3 held on the reticle drive stage 11 by superimposing it on the wafer, it is necessary to drive the two stages (11 and 3) in tight synchronization as well as make the reticle R3 and wafer W1 coincide with each other in absolute position via the projection optical system 10. This makes it necessary to carry out base line measurements by the TTR method. Base line measurement operation will be described below.

The dummy reticle R4 is fed by the reticle drive stage 11 into an exposure range (base line measurement position) of the projection optical system 10 (Step S101). The dummy reticle R4 uses a lamination of exposure light reflecting films as its parent material. The mark M7 is formed by arranging absorbing members on the parent material in such a way that reflected light which is slit-shaped in the X and Y directions will enter the projection optical system 10.

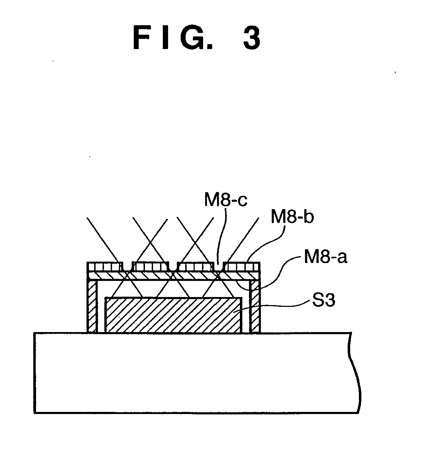

Next, the wafer drive stage 3 is moved in such a way as to position the dummy wafer W3 under the projection optical system 10 (at the base line measurement position) (Step S102). The mark M8 is placed on the dummy wafer W3. The mark M8 which is a slit-shaped transparent part of the same size as the mark M7 (but scaled down by the projection optical system) is formed by placing a light shielding member on an exposure light-transmitting member. An enlarged schematic view of the mark on the dummy wafer W3 and part around the light quantity detection sensor S3 are shown in FIG. 3. A thin film M8-a in FIG. 3 is made of Si, SiC, SiNx, diamond, or diamond-like carbon and is 2 µm or less in thickness. The mark M8 with a transparent area M8-c of the same shape as a reflecting area of the mark M7 on the dummy reticle R4 which is a projected body is formed on the thin film M8-a. The mark M8 is made of a tantalum, tungsten, or other light shielding member M8-b. Thus, the mark M8 has a slit shape in the X and Y directions. Also, the mark M8 is located almost in the same plane as the exposure surface of the wafer W1 and right above the light quantity detection sensor S3 for alignment measurement. Incidentally, the patterns on the marks M7 and M8 are not limited to slit shape. The pattern on the mark M7 (the pattern of the reflector) and pattern on the mark M8 (the pattern in the transparent area) may have any shape as long as they are similar to each other and the pattern on the mark M7 is reduced at a reduction ratio of the projection optical system 10.

Next, the exposure light L2 is admitted (Step S103) and the wafer stage 3 is moved slightly in the X and Y directions by monitoring light quantity using the light quantity detection sensor S3 installed under the dummy wafer W3. By finding the position which maximizes the light quantities in the X and Y directions on the wafer stage 3, it is possible to align the reticle and wafer via the projection optical system (Steps S104 and S105). The position at which the light quantities are maximized corresponds to the position at which slit-shaped EUV light reflected by the mark M7 on the dummy reticle R4 passes through the slit-shaped transparent part (M8-c) of the mark M8 on the dummy wafer W3 efficiently. This is the position at which the marks (M7 and M8) on the reticle and wafer are superimposed when viewed through the projection optical system 10.

Furthermore, the position which maximizes the light quantity is found by moving the wafer stage 3 slightly in the Z direction, and thereby the best focus plane of the reticle pattern is detected (Steps S106 and S107). At the best focus, blurring due to defocusing of the slit-shaped EUV light reflected by the mark M7 on the dummy reticle R4 is minimized. This reduces stray caused by the light shielding part (M8-b) of the mark M8 on the dummy wafer W3, and consequently allows the EUV light to reach the light quantity detection sensor S3 efficiently. This makes it possible to detect the best focus plane at a maximum light quantity level. Consequently, X-Y position of the mark M7 on the dummy reticle R4, X-Y position of the mark M8 on the dummy wafer W3, and focus position are put in correspondence. In this state, the positions of the reticle drive stage 11 and wafer drive stage 3 are measured by the laser interferometer and stored (Step S108).

Next, the mark M8 on the dummy wafer W3 is moved to below the off-axis microscope 6 based on the measured values from the laser interferometer (hereinafter referred to as the interferometer basis). The position of the mark M8 is measured with reference to the index mark M3 by using the off-axis microscope 6. As described above, an offset of the optical axis of the off-axis microscope 6 (origin of the measurement coordinate system) in relation to the optical axis of the projection optical system 10, i.e., a base line BL, can be measured based on these measured values as well as on the measured values from the wafer stage laser interferometer (Step S109).

When the base line is determined, the center of measurement (origin) of the off-axis microscope 6 is aligned with the mark (center of shot) on the wafer W1 and the wafer drive stage is driven by the amount equivalent to the base line. This makes it possible to feed the center of shot on the wafer W1 to a position on the optical axis of the projection optical system 10. On the side of the reticle, the distance between the mark M7 on the dummy reticle R4 and mark M9 on the dummy reticle R3 has been measured by the interferometer and reticle microscope. If this distance is denoted by RL, by moving the reticle drive stage by RL from the position it was located during the base line measurement, it is possible to bring the center of shot on the wafer W1 into coincidence with the center of reticle image in the projection optical system 10.

The base line measurement is performed in this way. Subsequently, during an exposure operation, scan exposure is repeated by feeding the reticle R3 into place on the interferometer basis using the reticle drive stage, measuring the position of the mark on the wafer W1 using the off-axis microscope 6, and moving the wafer drive stage 3 by the amount equal to the base line. By performing the base line measurements and focus calibrations at certain intervals, it is possible to cancel out changes in the base line caused by various factors such as thermal deformation of various parts.

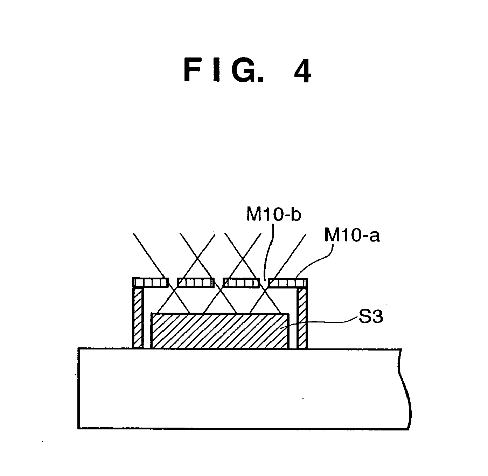

Incidentally, although in this embodiment, the mark M8 on the dummy wafer W3 is created by placing a metal as a light shielding member on an EUV-transparent parent material, there is no need to place a light shielding member on the transparent member as long as processing accuracy is achieved. For example, as shown in FIG. 4 a light shielding member M10-a with slits M10-b cut through it may be used. In this case, although the light shielding member M10-a is preferably as thin as possible, since the EUV-transparent part is provided as through-holes, there is no need to consider transmittance of the member, and thus the upper thickness limit of 2 µm is lifted. Also, since the light shielding member M10-a does not need to transmit EUV light, any metal or material suitable for machining can be freely selected as well as Si, SiC, SiNx, or diamond.

Thus, the first embodiment makes it possible to conduct TTR-based calibration measurement (base line measurement, image plane position measurement in the projection optical system, and the like) on an exposure apparatus which uses exposure light with a very short wavelength such as EUV light which is difficult to handle in a transmissive optical system.

### [Second Embodiment]

TTR measurement used mainly for base line correction has been described in the first embodiment, but the present invention is not limited to base line correction. For example, the present invention is useful for measurement of deviations in reticle stage and wafer state travels as well as for all measurement techniques which involve observing transmitted light by placing a mark in front of a sensor. As examples of such measurement, measurement of wavefront aberration in a projection optical system and measurement of pupil-fill intensity distribution (effective light source) will be described in a second embodiment.

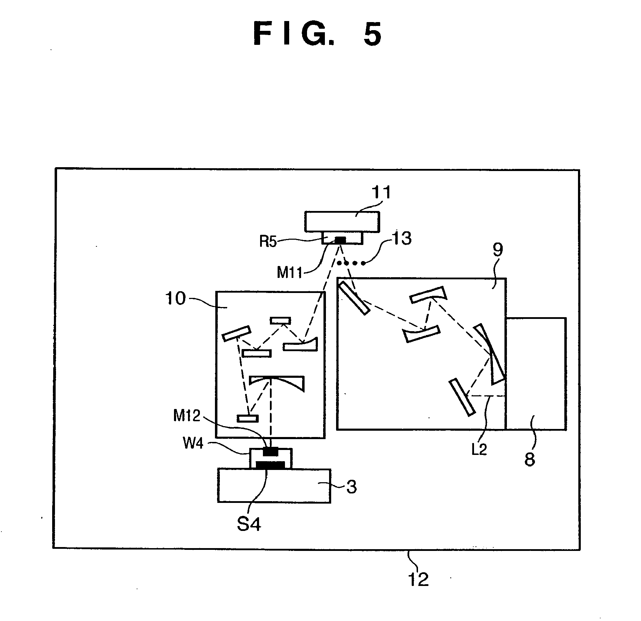

FIG. 5 is a schematic diagram showing a schematic configuration of an exposure apparatus according to the second embodiment. FIG. 5 shows a measurement system which is equipped with functions different from those of the first embodiment and which is used for an EUV exposure apparatus similar to that of the first embodiment in FIG. 1. The same components/functions as those in FIG. 1 are denoted by the same reference numerals/characters as the corresponding components/functions in FIG. 1. Whereas the configuration of the first embodiment implements base line measurement and the like (measurement of relative position between a reticle stage and wafer stage by the TTR method), the second embodiment has a configuration which has a function to measure aberration in a projection optical system.

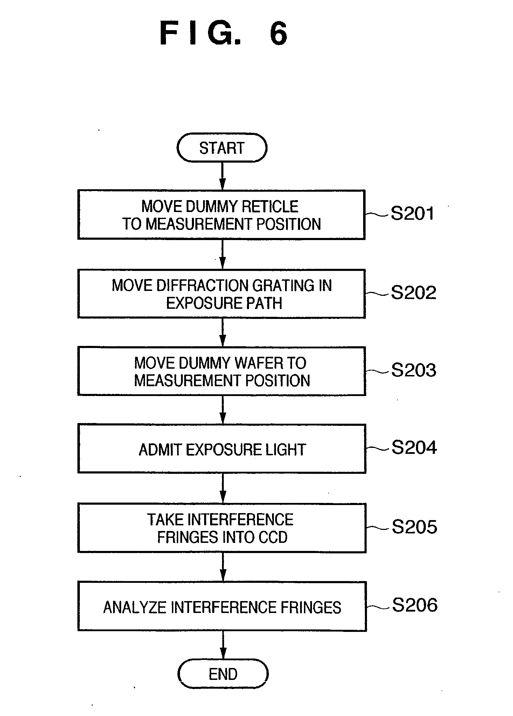

FIG. 6 is a flowchart showing procedures for aberration measurement according to this embodiment. Incidentally, the procedures shown in FIG. 6 are carried out as a controller (not shown) of the exposure apparatus according to this embodiment controls various parts of the exposure apparatus. The controller has a storage which stores a computer program corresponding to the procedures and CPU which executes the computer program stored in the storage. The second embodiment will be described in detail below with reference to FIGS. 5 and 6.

First, a reflective dummy reticle R5 (hereinafter referred to as the dummy reticle R5) is moved to a measurement position (Step S201) as shown in FIG. 5. A diffraction grating 13 is placed in an exposure path in front of or behind (in front of, in the case of FIG. 5) a reflecting surface of the reticle to diffract light as shown in FIG. 5. The diffraction grating 13 may be provided as lattice-like perforations produced mechanically in a metal or other member which shields EUV. Alternatively, the diffraction grating 13 may be produced by attaching light shielding bands of tungsten, tantalum, or the like to a thin film of SiC, Si, SiNx, diamond, or diamond-like carbon 2 µm or less in thickness. Incidentally, when attaching the light shielding bands to a thin film, the diffraction grating can be produced by a method similar to that of the optical element. Next, a dummy wafer W4 is moved to a measurement position, such as shown in FIG. 5 (Step S203). After that, exposure light (EUV light) is directed into the illumination optical system 9 from the light source 8.

Incidentally, absorbing members are arranged on a reflecting surface of a mark M11 on the dummy reticle R5 so that part which reflects the diffracted light from the diffraction grating 13 will have a very fine slit or pinhole. The reflecting surface with the slit or pinhole cancels out the aberration caused by the illumination optical system 9 and makes illuminating EUV light with an ideal wavefront enter the projection optical system 10.

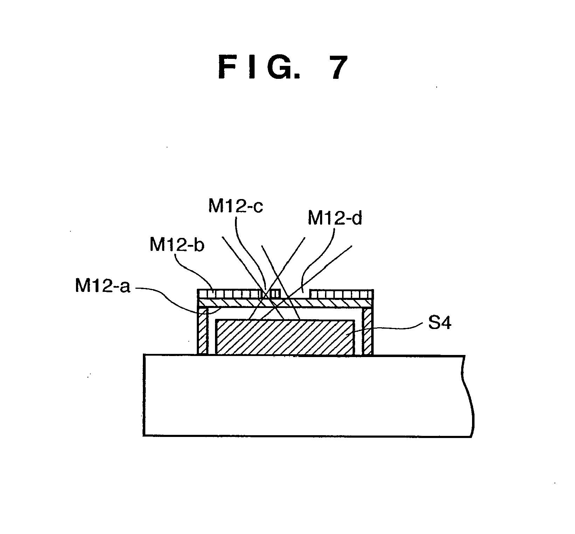

The dummy wafer W4 placed near a wafer-side image plane has a parent material transparent to EUV light similar to that of the first embodiment, and a mark M12 with a light shielding member arranged in a predetermined pattern is formed on the parent material. The parent material is a thin film of Si, SiC, SiNx, diamond, or diamond-like carbon 2 µm or less in thickness. The light shielding member is made of tungsten, tantalum, or the like. The mark M12 is formed by placing a light shielding member on the ' parent material in such a way as to form a slit-shaped or pinhole-shaped transparent region and a window-shaped transparent region with a large transparent area. A CCD camera S4 for EUV is placed under the mark M12 on the wafer image plane. FIG. 7 is an enlarged schematic view of a region near the mark M12 of the dummy wafer W4. The mark M12 with a slit-shaped or pinhole-shaped transparent part M12-c and a window-shaped transparent part M12-d is formed by placing a light shielding member M12-b on a thin film M12-a which, being made of one of the above-described materials and having a thickness within the above-described range, transmits EUV light.

As described above, the mark M11 placed on the dummy reticle R5 and equipped with the slit-shaped or pinhole-shaped reflector allows EUV light with an aberration-free ideal wavefront to enter the projection optical system 10. Consequently, the EUV light coming out of the projection optical system 10 only contains aberration attributable to the projection optical system. As the EUV light passes through the slit-shaped or pinhole-shaped transparent part M12-c in FIG. 7, the aberration contained in the EUV light is cancelled out, and consequently the EUV light reaches a plane of the CCD camera S4 as an ideal wavefront. Preferably, the CCD camera S4 consists of a light-sensitive element which is sensitive to EUV light. However, a CCD camera for visible radiation may also be used if it is configured to detect fluorescence which is produced through scintillation by a scintillator placed in front of the CCD camera and which is guided to the CCD camera via a fiber-optic plate.

On the other hand, the EUV light passing through the window-shaped transparent part M12-d in FIG. 7 reaches the plane of the CCD camera S4, still containing the aberration caused by the projection optical system 10. The EUV light passing through the transparent part M12-c is used as a reference beam and the EUV light passing through the window-shaped transparent part M12-d is used as a sample beam. The difference between the wavefronts of the two lights is wavefront aberration caused by the projection optical system 10. When taken into the CCD camera S4, the wavefront aberration is observed as interference fringes caused by the reference beam and sample beam. If the interference fringes are subjected to image processing, image processing of the interference fringes by means of an electronic moire technique makes it possible to measure wavefront aberration quantitatively up to the 36th term of Zernike polynomials (Step S206).

An example of how to produce interference fringes on the CCD camera plane has been described in the second embodiment, but this is not restrictive. For example, a conceivable technique involves directing EUV light in which aberration is cancelled out by a slit-shaped or pinhole-shaped reflector on a reticle surface into the projection optical system, producing interference fringes using difference in wavefront aberration between the 0th-order light and first-order light by placing a diffraction grating on the wafer image plane, observing the interference fringes with a CCD camera, and measuring the wavefront aberration through integrating and image processing. In this case, the configuration consisting of a light shielding member placed on the EUV-transparent member (M12-a) may be used as the diffraction grating installed near the wafer-side image plane (approximately the same plane as the exposed surface of the wafer).

Also, measurement of wavefront aberration has been described in the second embodiment, but an effective-light-source measurement system for measurement of pupil-fill intensity distribution in the illumination optical system can be obtained by removing the diffraction grating 13 and making pinholes in both reticle-side image plane (object plane) and wafer-side image plane. In this case, the pinhole in the wafer-side image plane can be produced by placing a light shielding member made of tungsten, tantalum, or the like on an EUV-transparent member of Si, SiC, SiNx, diamond, or diamond-like carbon 2 µm or less in thickness in such a way as to leave a pinhole-shaped transparent part.

Thus, by using a light-transmitting member of a material (Si, SiC, SiNx, diamond, or diamond-like carbon) and thickness (2 µm or less) cited in the above embodiments, it is possible to obtain an optical element which can be used for various measurements of EUV light passing through a predetermined pattern (slit, pinhole, diffraction grating, or the like). Incidentally, various patterns for optical elements are conceivable in addition to those cited in the first and second embodiments. For example, the above technique is also available for use to form a diffraction pattern leading to a predetermined pupil-fill intensity distribution in the illumination optical system, as an optical element with a function similar to that of the diffraction grating. In this embodiment, as is the case with the first embodiment, a transparent part may be punctured in a light shielding member instead of placing a light shielding member on a transparent member as long as processing accuracy is achieved.

As described above, the first and second embodiments make it possible to conduct various measurements using EUV light on the EUV-based exposure apparatus, including TTR-based measurement of relative positional relationship between a wafer and reticle (measurement of relative positional relationship in directions perpendicular and/or parallel to the optical axis of a projection optical system), measurement of aberration in the projection optical system, or measurement of pupil-fill intensity distribution of a illumination optical system. Thus, it is possible to conduct various measurements using exposure light passing through a predetermined pattern on an EUV exposure apparatus or other exposure apparatus which uses exposure light with a very short wavelength which is difficult to handle in a transmissive optical system. This in turn makes it possible, for example, to always perform high accuracy focusing and alignment or optimize performance of the optical system, and thus transfer fine circuit patterns in a stable manner.

### [Third Embodiment]

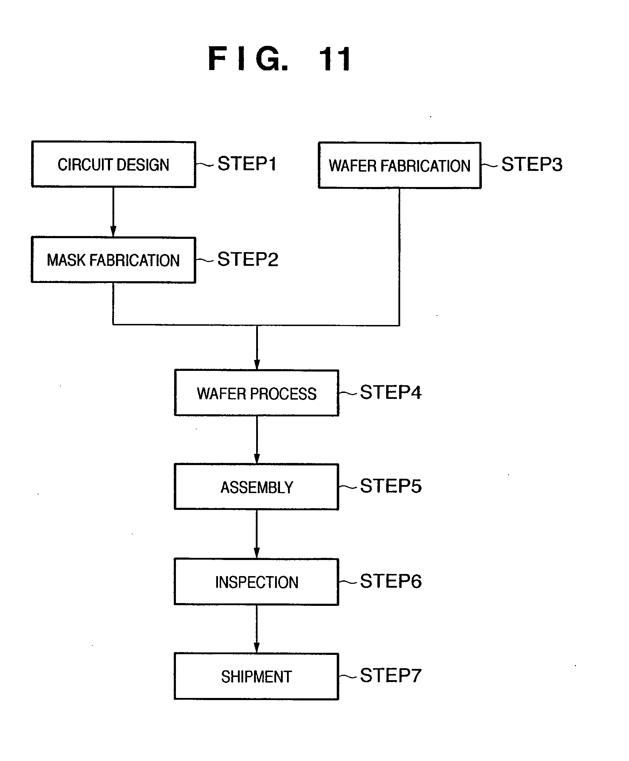

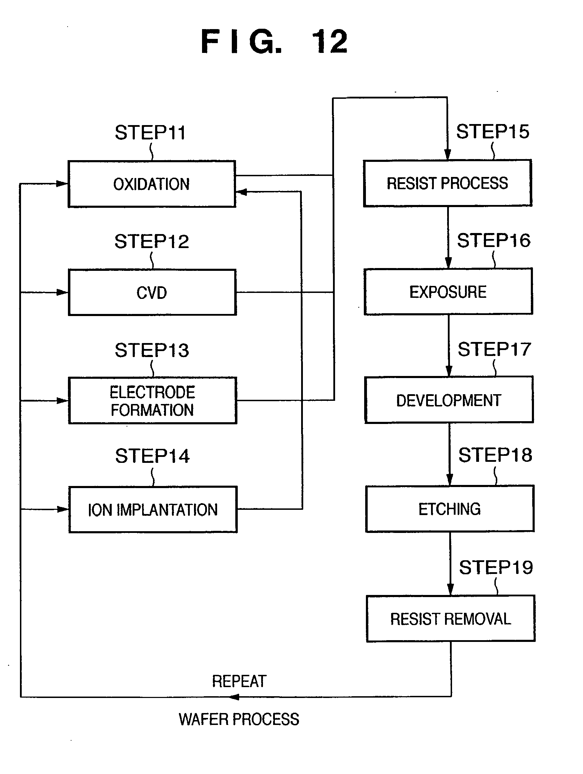

Now, a device manufacturing method which used the above-described exposure apparatus will be described with reference to FIGS. 11 and 12.

FIG. 11 is a flowchart illustrating manufacture of a device (IC, LSI, or other semiconductor chip, LCD, CCD, or the like). This embodiment will be described, taking manufacture of a semiconductor chip as an example. In Step S1 (circuit design), a circuit of the device is designed. In Step S2 (mask fabrication), a mask (also known as a reticle) is fabricated using the designed circuit pattern. In Step S3 (wafer fabrication), wafer is fabricated using silicon or other material. In Step S4 (wafer process), which is called a front-end process, actual circuits are formed on the wafer by lithography technology using the mask and wafer. In Step S5 (assembly), which is called a back-end process, semiconductor chips are produced from the wafer fabricated in Step S4. This step includes an assembly process (dicing and bonding), packaging process (chip encapsulation), and other processes. In Step S6 (inspection), inspections are performed, including an operation checking test and durability test of the semiconductor device fabricated in Step S5. The semiconductor device is completed through these processes, and shipped out subsequently (Step S7).

FIG. 12 is a detailed flowchart of the wafer process in Step S4. In Step S11 (oxidation), a surface of the wafer is oxidized. In Step S12 (CVD) an insulating film is formed on the wafer surface. In Step S13 (electrode formation), electrodes are formed on the wafer by vapor deposition. In Step S14 (ion implantation), ions are implanted into the wafer. In Step S15 (resist process), a photosensitive material is applied to the wafer. In Step S16 (exposure), the wafer is exposed through the mask by the exposure apparatus. In Step S17 (development), the exposed wafer is developed. In Step S18 (etching), part other than the developed resist image is etched. In Step S19 (resist removal), any unnecessary resist remaining after the etching is removed. As these steps are repeated, a multiple layers of circuit patterns are formed on the wafer. The device manufacturing method according to this embodiment can manufacture devices of higher quality than conventional ones. Thus, the device manufacturing method using the exposure apparatus as well as resulting devices also constitute an aspect of the present invention.

These embodiments provide an optical element suitable for extreme ultraviolet light-based measurement for which it is difficult to use a transmissive optical element, exposure apparatus incorporating the optical element, and device manufacturing method using the exposure apparatus.

As many apparently widely different embodiments of the present invention can be made without departing from the spirit and scope thereof, it is to be understood that the invention is not limited to the specific embodiments thereof except as defined in the appended claims.

## Claims

1. An optical element for an exposure apparatus which has a projection optical system configured to project a pattern of an original plate illuminated with extreme ultraviolet light from a light source onto a substrate and exposes the substrate to the light via the original plate and said projection optical system, said optical element being to be placed in one of a first path of the light located in a side of the light source with respect to the original plate and a second path of the light located in a side of the substrate with respect to the original plate, said element comprising:
a film configured to transmit the extreme ultraviolet light; and
a shield placed on said film and configured to shield part of said film from the extreme ultraviolet light.

2. An element according to claim 1, wherein said film is made of at least one of Si, SiC, SiNx, diamond, and diamond-like carbon and has thickness not greater than 2 µm.

3. An exposure apparatus which has a projection optical system configured to project a patterns of an original plate illuminated with extreme ultraviolet light from a light source onto a substrate and exposes the substrate to the light via the original plate and said projection optical system, said apparatus comprising:
an optical element as defined in claim 1 configured to be placed in one of a first path of the light located in a side of the light source with respect to the original plate and a second path of the light located in a side of the substrate with respect to the original plate.

4. An apparatus according to claim 3, wherein said optical element is configured to be placed at a position in the second path at which the substrate is to be placed.

5. An exposure apparatus which exposes a substrate to extreme ultraviolet light via an original plate, said apparatus comprising:
a projection optical system configured to project a pattern of the original plate onto the substrate:
a substrate stage configured to hold the substrate and to move;
an optical element as defined in claim 1 placed on said substrate stage; and
a detector configured to detect extreme ultraviolet light emitted from said projection optical system and transmitted through said optical element.

6. An apparatus according to claim 5, further comprising:
an original plate stage configured to hold the original plate and to move;
a mark placed on said original plate stage;
an illumination optical system configured to illuminate the mark with extreme ultraviolet light; and
a controller configured to adjust relative position between said substrate stage and said original plate stage based on output from said detector which receives light reflected off the mark illuminated by said illumination optical system, via said projection optical system and said optical element.

7. An apparatus according to claim 5, further comprising:
an original plate stage configured to the original plate and to move;
a reflective element placed on said original plate stage; and
a diffractive element configured to be placed in a path of the extreme ultraviolet light and to diffract the extreme ultraviolet light,
wherein said optical element includes two transparent parts configured to generate a reference beam and a sample beam from two beams of the extreme ultraviolet light, respectively, the two beams being received by said optical element via said reflective element, said diffractive element and said projection optical system, and
said detector is configured to detect light intensity distribution due to interference of the reference beam and the sample beam.

8. An apparatus according to claim 7, wherein said diffractive element is configured as an optical element as defined in claim 1.

9. An apparatus according to claim 5, further comprising:
an original plate stage configured to hold the original plate and to move; and
a reflective element placed on said original plate stage,
wherein said optical element includes a transmissive part configured to transmit extreme ultraviolet light for measuring an effective light source, and
said detector is configured to detect intensity distribution of extreme ultraviolet light received via said reflective element, said projection optical system and said optical element.

10. A method of manufacturing a device, said method comprising steps of:
exposing a substrate to light via an original plate using an exposure apparatus as defined in claim 3;
developing the exposed substrate; and
processing the developed substrate to manufacture the device.
